# EUROPEAN PATENT SPECIFICATION

(11) **EP 2 600 524 B1**
(45) Date of publication and mention of the grant of the patent: **30.03.2016**
(21) Application number: 12193994.6
(22) Date of filing: 23.11.2012
(51) Int. Cl.: H03F 3/181, H03F 3/68, G10K 11/178, H04R 5/04, H04R 5/033

(54) **Adaptive crosstalk rejection**
Adaptive Übersprechunterdrückung
Rejet de diaphonie adaptative

(30) Priority: 28.11.2011 US 201161564278 P
(43) Date of publication of application: 05.06.2013
(73) Proprietor: Sony Mobile Communications AB, 221 88 Lund (SE)
(72) Inventor: Birch, Magnus, 22188 Lund (SE); Ullen, Kaj, 22188 Lund (SE)
(74) Representative: Hoffmann Eitle

(56) References cited:
- WO-A1-2010/022801
- DE-A1- 2 716 039
- US-A1- 2003 179 892
- US-A1- 2006 023 889
- US-A1- 2008 008 325
- US-A1- 2008 085 010
- US-A1- 2011 096 931

## Description

### BACKGROUND

Crosstalk is any phenomenon by which a signal transmitted in one system (or a part of the system such as a channel or segment of the system) can create an undesirable effect in another system (or in a different part of the same system). In an audio-producing system that includes multiple audio-listening channels, an undesirable effect may include reduced audio quality (e.g., noisy audio, static, or other interference) on one or more of the audio-listening channels. In some instances, this undesirable effect may be caused by impedance or resistance associated with a common path shared by the one or more audio listening channels. Therefore, what is needed is a system to reduce the crosstalk between systems or between parts of the same system.

US 2008/008325 A1 discloses crosstalk cancellation using load impedance measurements.

### BRIEF SUMMARY

In the embodiments, an exemplary method of the invention includes detecting a first audio-listening channel and a second audio-listening channel. Additionally, the method includes in response to detecting the first audio-listening channel and the second audio-listening channel, transmitting from a first signal source, a first input signal to a first amplifier associated with a first audio-listening channel. Additionally, the method includes measuring a signal level along at least a portion of a common path shared by the first audio-listening channel and the second audio-listening channel, wherein the common path includes at least some resistance. In some embodiments, this measuring step may be performed at a frequency associated with the first input signal. Additionally, the method includes determining a compensation signal to be injected into the second audio-listening channel based at least partially on the measured signal level. Additionally, the method includes injecting at least a part of the first input signal into the second audio-listening channel based at least partially on the determined compensation signal, thereby reducing a current level in the second audio-listening channel.

Additionally, in some embodiments, the method further includes: measuring a current level in the first audio-listening channel; measuring a current level in the second audio-listening channel; and comparing the current level in the first audio-listening channel and the current level in the second audio-listening channel to determine a difference between the current level in the first audio-listening channel and the current level in the second audio-listening channel is greater than a predetermined threshold level.

Additionally, in some embodiments, the method includes transmitting from a second signal source a second input signal to a second amplifier associated with the second audio-listening channel. Additionally, the method includes measuring a signal level along a at least a partial portion of the common path shared by the first audio-listening channel and the second audio-listening channel, wherein the common path includes at least some resistance. In some embodiments, this measuring step may be performed at a frequency associated with the second input signal. Additionally, the method includes determining a compensation signal to be injected into the first audio-listening channel based at least partially on the measured signal level. Additionally, the method includes injecting at least a part of the second input signal into the first audio-listening channel based at least partially on the determined compensation signal or the measured signal level, thereby reducing a current level in the first audio-listening channel.

Additionally, in some embodiments, the step of injecting at least a part of the first input signal into the second audio-listening channel is performed substantially simultaneously with the injecting at least a part of the second input signal into the first audio-listening channel.

Additionally, in some embodiments, the signal source is a voltage source and the signal level is a voltage level. Additionally, in some embodiments, the first audio-listening channel includes a first earphone associated with a first impedance and the second audio-listening channel includes a second earphone associated with a second impedance. Additionally, in some embodiments, the first impedance is different from the second impedance. Additionally, in some embodiments, the first input signal is associated with a first frequency and the second input signal is associated with a second frequency different from the first frequency.

Additionally, in some embodiments, at least one of the transmitting step, the measuring step, the determining step, or the injecting step is performed in the digital domain.

Additionally, in some embodiments, the step of detecting further comprises: detecting a connector is inserted into an audio-producing system, wherein the connector is associated with the first audio-listening channel and the second audio-listening channel. In some embodiments, this connector may be part of the common path shared between the first audio-listening channel and the second audio-listening channel.

Additionally, in some embodiments, the method further comprises: in response to detecting the first audio-listening channel and the second audio-listening channel, producing an audible beep.

Additionally, in some embodiments, the method further comprises: determining a first impedance associated with the first audio-listening channel; determining a second impedance associated with the second audio-listening channel; and measuring the signal level along the common path based at least partially on the first impedance and the second impedance.

Additionally, in some embodiments, the measuring step further comprises: disabling an injecting module that performs the injecting. Additionally, in some embodiments, the measuring further comprises: disabling an input signal provided to an amplifier located in the measuring module; and maximizing a gain associated with the amplifier located in the measuring module. The measuring step is performed by a measuring module described herein.

Additionally, in some embodiments, the step of measuring a signal level along at least a partial portion of the common path shared by the first audio-listening channel and the second audio-listening channel further comprises measuring an output signal level associated with the first amplifier and measuring an output signal level associated with the second amplifier.

Additionally, in some embodiments, the step of measuring a signal level along at least a partial portion of the common path shared by the first audio-listening channel and the second audio-listening channel further comprises measuring an input signal level associated with an amplifier located in the measuring module.

Additionally, in some embodiments, the step of measuring a signal level along at least a partial portion of the common path shared by the first audio-listening channel and the second audio-listening channel further comprises using a compensation factor associated with the configuration of the measuring module.

Additionally, in some embodiments, the measuring module includes a circuit comprising a microphone.

Additionally, in some embodiments, the method further includes: measuring a current level in the second audio-listening channel; and comparing the current level in the second-audio listening channel and a predetermined threshold current level to determine that the current level in the second audio-listening channel is greater than the predetermined threshold current level.

Additionally, in some embodiments, the method includes providing an application; determining a maximum crosstalk value associated with the application; comparing a current level in the first audio-listening channel and a current level in the second audio-listening channel to determine a measured crosstalk value; comparing the measured crosstalk value and the maximum crosstalk value to determine that the measured crosstalk value is less than or equal to the maximum crosstalk value; and permitting execution of the application.

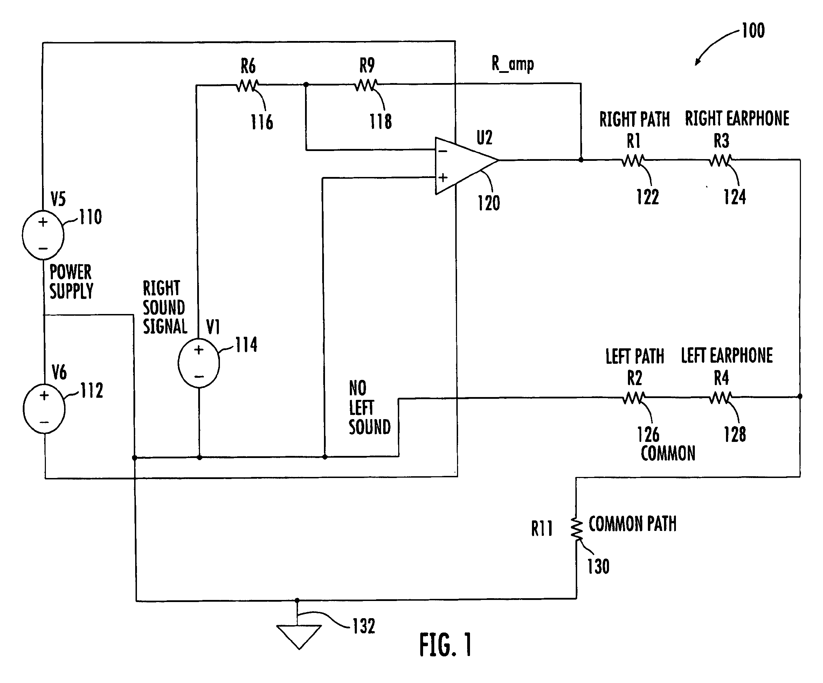

An exemplary system of the invention comprises a memory, a processor, and other circuitry as described herein and illustrated in Figures 1, 3, 5, 7, and 8. The system further comprises a module stored in the memory, executable by the processor, and configured to: detect a first audio-listening channel and a second audio-listening channel; in response to detecting the first audio-listening channel and the second audio-listening channel, transmit, from a first signal source, a first input signal to a first amplifier associated with a first audio-listening channel; measure a signal level over at least a portion of a common path shared by the first audio-listening channel and a second audio-listening channel, wherein the common path includes at least some resistance; determine a compensation signal to be injected into the second audio-listening channel based at least partially on the measured signal level; and divert at least a part of the first input signal to the second audio-listening channel based at least partially on the determined compensation signal, thereby causing an output signal level of a second amplifier associated with the second audio-listening channel to substantially match the signal level over the common path.

An exemplary computer program product comprises a non-transitory medium comprising a set of codes that cause a computer to: detect a first audio-listening channel and a second audio-listening channel; in response to detecting the first audio-listening channel and the second audio-listening channel, transmitting, from a first signal source, a first input signal to a first amplifier associated with a first audio-listening channel; measure a signal level along at least a portion of a common path shared by the first audio-listening channel and a second audio-listening channel, wherein the common path includes at least some resistance; determine a digital compensation signal to be injected into the second audio-listening channel based at least partially on the measured signal level; and inject at least a part of the first input signal into the second audio-listening channel based at least partially on the determined compensation signal, thereby reducing a current level in the second audio-listening channel.

### BRIEF DESCRIPTION OF THE DRAWINGS

Having thus described embodiments of the invention in general terms, reference will now be made to the accompanying drawings, where:
Figure 1 presents a diagram of an embodiment of a system that illustrates how crosstalk is generated between parts of a system;
Figure 2 presents a simulation graph associated with the system presented in Figure 1, in accordance with embodiments of the present invention;
Figure 3 presents a diagram illustrating a sending channel of a system that generates a compensation signal which rejects crosstalk on a victim channel, in accordance with embodiments of the present invention;
Figure 4 presents a simulation graph associated with the system presented in Figure 3, in accordance with embodiments of the present invention;
Figure 5 presents a diagram illustrating a system that rejects crosstalk between two channels of a system that communicate signals simultaneously or nearly simultaneously, in accordance with embodiments of the present invention;
Figure 6 presents a simulation graph associated with the system presented in Figure 5, in accordance with embodiments of the present invention;
Figure 7 presents a diagram of a first part of a system that permits measurement of a signal level or resistance over a common path of the system, in accordance with embodiments of the present invention;
Figure 8 presents a diagram of second part of a system that permits measurement of a signal level or resistance over a common path of the system, in accordance with embodiments of the present invention;
Figure 9 presents a simulation graph associated with the system presented in Figure 5, in accordance with embodiments of the present invention; and
Figure 10 presents a flowchart illustrating a general process flow for reducing crosstalk between two systems or between parts of the same system, in accordance with embodiments of the present invention.

### DETAILED DESCRIPTION OF EMBODIMENTS OF THE INVENTION

Embodiments of the present invention now may be described more fully hereinafter with reference to the accompanying drawings, in which some, but not all, embodiments of the invention are shown. Indeed, the invention may be embodied in many different forms and should not be construed as limited to the embodiments set forth herein; rather, these embodiments are provided so that this disclosure may satisfy applicable legal requirements. Like numbers refer to like elements throughout.

Embodiments of the invention are directed to systems, methods and computer program products for reducing crosstalk between two systems or between parts of the same system. As used herein, a system may refer to a circuit such as the circuit presented in Figures 1, 3, 5, 7 and 8. In some embodiments, a system may include a receiving module to connect to personal hands free ("PHF") earphone hardware that includes one or more earphones (e.g., two earphones). The PHF earphone hardware may include one or more circuits or circuit fragments that interact with the system described herein. As used herein, an earphone is an audio speaker that is held close to a person's ear and is connected to an audio signal source such as an audio amplifier, portable media player, radio, etc. In some embodiments, the multiple earphone channels maybe located in the same housing (e.g., chassis), while in other embodiments, each of the multiple earphone channels may be located in separate housings.

When the PHF earphone hardware receives audio signals from an audio-producing source, crosstalk between the one or more earphone channels of the PHF earphone hardware occurs because of the impedance or resistance on the common path or channel shared between the earphones. In some embodiments, the common path or channel may be a connector (e.g., a 3.5mm connector) that connects the earphones to an audio producing device or system. The impedance or resistance on the common path may occur because of several reasons. For example, the common path may include a radio tuning coil, one or more switches for television output for OMPTP/CTIA (Color Television Interface Adaptor) automatic configuration, ferrite polymer composites (FPCs) and/or ferrites to handle various electromagnetic compatibility (EMC) issues, etc. Each of these elements may add impedance or resistance to the common path.

In some embodiments, crosstalk, as referred to herein, may refer to introduction of noise from one earphone channel onto another earphone channel. In such embodiments, a measurement of crosstalk in the system yields a decibel (dB) value relative to a nominal signal level on the earphone channel receiving the noise from the other earphone channel. In other embodiments, the crosstalk occurs because of ground currents or stray inductance or capacitance between the multiple earphone channels.

By reducing the crosstalk between the multiple earphone channels, the invention provides a higher quality listening experience to one for more listeners listening to audio transmitted through multiple earphone channels. Additionally, some applications (e.g., filmmaking applications) that involve the subject earphone hardware may specify levels of crosstalk that should not be exceeded in order to execute the applications or in order to achieve optimal performance of the applications. In some embodiments, an application that is initiated by a user on a system or device (e.g., portable computing device, personal computing device, etc.) may initially determine whether a crosstalk level associated with subject earphone hardware is exceeded. In such embodiments, the application may be automatically configured to execute the crosstalk reduction method described herein as part of the application initiation process. In some embodiments, the application may indicate to a user of the device that the application cannot be executed on the device unless the user initiates execution of the crosstalk reduction method as described herein.

Additionally, the systems, methods, and computer program products described herein can be adapted to be used with other PHF earphone hardware. As used herein, earphone hardware may include one earphone, two earphones, or more than two earphones. For example, a computer program product described herein that is embodied as a software program can be installed in an audio player that is connected to earphone hardware or can be installed in a computer that is connected to earphone hardware. In still other embodiments, the software program may be directly programmed into programmable earphone hardware. The installed software reduces crosstalk between multiple earphone channels associated with the earphone hardware. As used herein, an earphone channel may be a type of audio-listening channel. In some embodiments, the installed software is always active. In other embodiments, the installed software is activated when the earphone hardware receives electrical signals to convert into audible sound or when the earphone hardware emits audible sound. Embodiments of the present invention (including any hardware or software associated with embodiments of the present invention) can be adapted to be used with (or can be tuned to work with) any audio-listening device (e.g., wired or wireless headphones, earphones, etc.) that includes one or more earphones.

With respect to the system diagrams presented in Figures 1, 3, 5, 7, and 8, there are several instances where two connections (e.g., wires) are illustrated as crossing each other. In instances where a dot (●) is presented at the point of intersection, the two connections are shorted or ganged together. In instances where a dot (●) is not presented at the point of intersection, the two connections are not shorted or ganged together.

Referring now to Figure 1, Figure 1 presents an illustration of how crosstalk is generated in a system. The system **100** includes a circuit as presented in Figure 1. In Figure 1, V5 **110** and V6 **112** are voltage sources that are part of the power supply for the circuit. A ground connection **132** is provided for the system. R1 **122,** R2 **126,** R3 **124,** R4 **128, R6 116,** R9 **118,** and R11 **130** are resistors. R1 **122** and R3 **124** are resistors on the path that includes the right earphone. R3 **124** represents the right earphone. R2 **126** and R4 **128** are resistors on the path that includes the left earphone. R4 **128** represents the left earphone. R11 **130** is a resistor on the common path shared by the right and left earphones. V1 **114** is a voltage source or sound generator that sends out a signal (e.g., a 1 kHz signal) that is used as input to the amplifier U2 **120.** U2 **120** is an amplifier (e.g., an operational amplifier) that drives current through the right earphone, R3 **124.** Therefore, the system presented in Figure 1 causes a 1kHz sound signal to be injected at (or diverted to) the right earphone, R3 **124.** The current that is driven through R3 **124** is split up into two paths. The current along one path travels through the left earphone, R4 **128.** In some embodiments (e.g., embodiments that include a mobile device), R3 **124** and R4 **128** may take values between 15 and 50 Ohms. However, embodiments of the invention also work well for impedance values for R3 **124** and R4 **128** above and below this impedance span. Embodiments of the invention are not limited to any particular values for R3 **124** and R4 **128.** In a line-out configuration, R3 **124** and R4 **128** may take values of thousands of Ohms and, in such a configuration, the crosstalk is small for the earphone hardware. However, crosstalk increases as the values of R3 **124** and R4 **128** decrease, and as the crosstalk increases, the need for the invention described herein becomes more urgent. For instance, the crosstalk for a system is very large when the values of R3 **124** and R4 **128** decrease to 15 Ohms. The current along another path travels through the resistor, R11 **130,** on the common path. As used herein, one method of measuring crosstalk for the system presented in Figure 1 is by measuring the amount of current traveling through the left earphone, R4 **128,** relative to the amount of current traveling through the resistor R11 **130** on the common path. As used herein, another method of measuring crosstalk for the system presented in Figure 1 is by measuring the different between the amount of current traveling through the right earphone, R3 **124,** and the amount of current traveling through the left earphone, R4 **128.** As indicated in Figure 1, the system does not include a voltage source that sends out a signal that is used as input to an amplifier that drives a current through the left earphone, R4 **128.** Therefore, in the embodiment presented in Figure 1, no audio signal is injected at (or diverted to) the left earphone, R4 **128.**

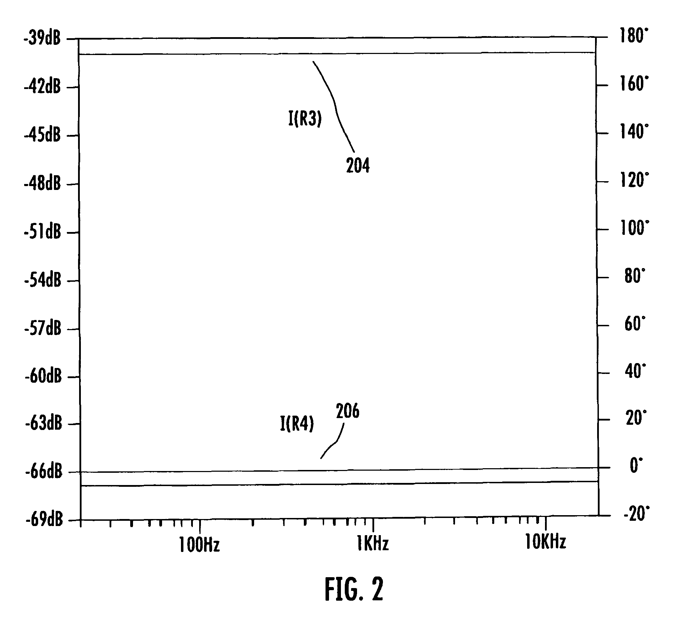

Referring now to Figure 2, Figure 2 presents a simulation or a frequency response chart associated with the system presented in Figure 1, in accordance with embodiments of the present invention. As used herein, a "level" may also be referred to as an amplitude associated with a signal waveform. As used herein, a voltage level may also be referred to as a signal level. As presented in Figure 2, the current **204** measured through the right earphone, R3, is -40 dB. As used herein, the decibel (dB) is a logarithmic unit that indicates a ratio of a physical quantity with respect to a reference value (e.g., relative to 1A for current measurement and 1V for voltage measurement). Additionally, as presented in Figure 2, the current **206** measured through the left earphone, R4, is -67 dB. The measured crosstalk for the system is the difference between the current **204** measured through R3 and the current **206** measured through R4. Therefore, the crosstalk is -27 dB.

In some embodiments, after measuring the crosstalk for the system, the system may present, on a user interface associated with the system, a list of applications that can be executed using the system. In embodiments of the system, each application may have a particular crosstalk requirement. If the crosstalk requirement of an application is greater than the measured crosstalk (e.g., greater than -27 dB), the system may present that application as an available executable application option. If the crosstalk requirement of an application is smaller than the measured crosstalk (e.g., smaller than -27 dB), the system may not present that application as an available executable application option.

In alternate embodiments, a system as described herein may determine a maximum crosstalk value associated with an application in response to a user of the system initiating execution of the application. Additionally, in response to the user initiating execution of the application, the system may determine a difference in current level between the right earphone channel and the left earphone channel by comparing the current levels of the right earphone channel and the left earphone channel, where the determined difference is a measured crosstalk value. Subsequently, the system compares the measured crosstalk value and the maximum crosstalk value. In response to determining the measured crosstalk value is less than or equal to the maximum crosstalk value, the system permits initiation of the application. In response to determining the measured crosstalk value is greater than the maximum crosstalk value, the system does not permit initiation of the application, and instead presents a message to a user via a display associated with the system, where the message informs the user that the measured crosstalk value exceeds the maximum permitted crosstalk value for initiation of the application.

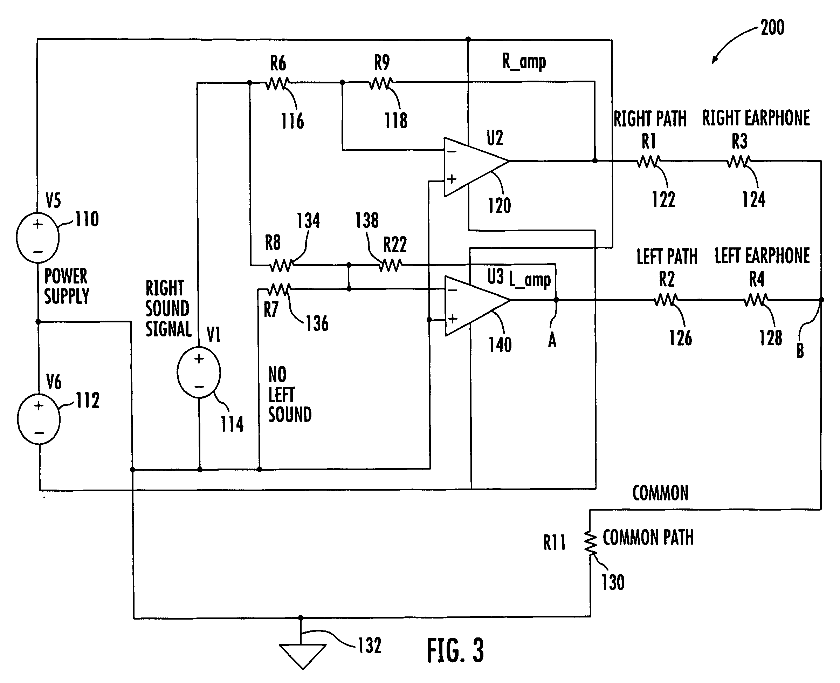

Referring now to Figure 3, Figure 3 presents a diagram illustrating a sending channel of a system **200** that generates a compensation signal which rejects crosstalk on a victim channel, in accordance with embodiments of the present invention. In Figure 3, the sending channel is the channel associated with the right earphone, R3 **124,** and the victim channel is the channel associated with the left earphone, **R4 128.** In the embodiment presented in Figure 3, the sending channel generates a compensation signal that rejects the crosstalk on the victim channel. The description of the system with respect to Figure 1 also applies to the system presented in Figure 3. In addition to the elements described in Figure 1, Figure 3 includes resistors R7 136, R8 **134,** and R22 **138.** Additionally, Figure 3 includes amplifier U3 **140** (e.g., operational amplifier). As indicated in Figure 3, at least some part of the sound signal (e.g., 1 kHz signal) generated by the voltage source V1 **114** is transmitted as input to the amplifier U3 **140.** Amplifier U3 **140** generates a voltage on L_amp (e.g., the voltage measured at point A). This voltage may substantially mirror or match the voltage at the common node (e.g., the voltage measured at point B). Since the voltage measured at point A substantially mirrors the voltage measured at point B, the current flowing through the left path and the left earphone, R4 **128,** decreases when compared to the embodiment presented in Figure 1. Since the current flowing through the left earphone, R4 **128,** decreases, the crosstalk that is measured for the system also decreases because as defined previously, the crosstalk for the system is the amount of current flowing through the left earphone, R4 **128,** relative to the amount of current flowing through the right earphone, R3 **124.** Just as in Figure 1, the system does not include a voltage source that sends out a signal that is used as input to an amplifier that drives a current through the left earphone, R4 **128.**

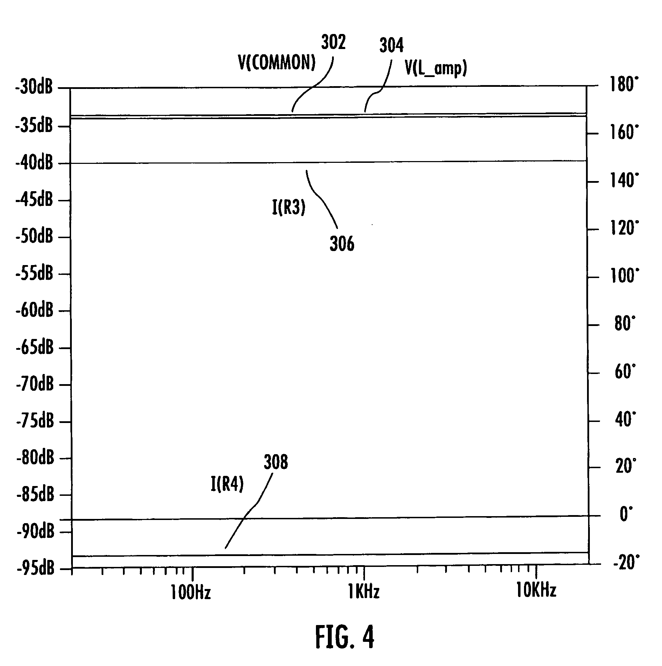

Referring now to Figure 4, Figure 4 presents a simulation or a frequency response chart associated with the system presented in Figure 3, in accordance with embodiments of the present invention. As presented in Figure 4, the voltage level **304** at node A (around -34 dBV) is almost the same as the voltage level **302** at node B (around -34 dBV). The current **306** measured through the right earphone, R3 **124,** is -40 dB, which is the same current level that was measured in Figure 2 with respect to the system presented in Figure 1. Additionally, as presented in Figure 4, the current **308** measured through the left earphone, R4 **128,** is -93 dB, which is lower than the current level that was measured for R4 in Figure 2 with respect to the system presented in Figure 1. Therefore, the crosstalk is -53 dB, which is less than the crosstalk measured for the system in Figure 1 (-36 dB).

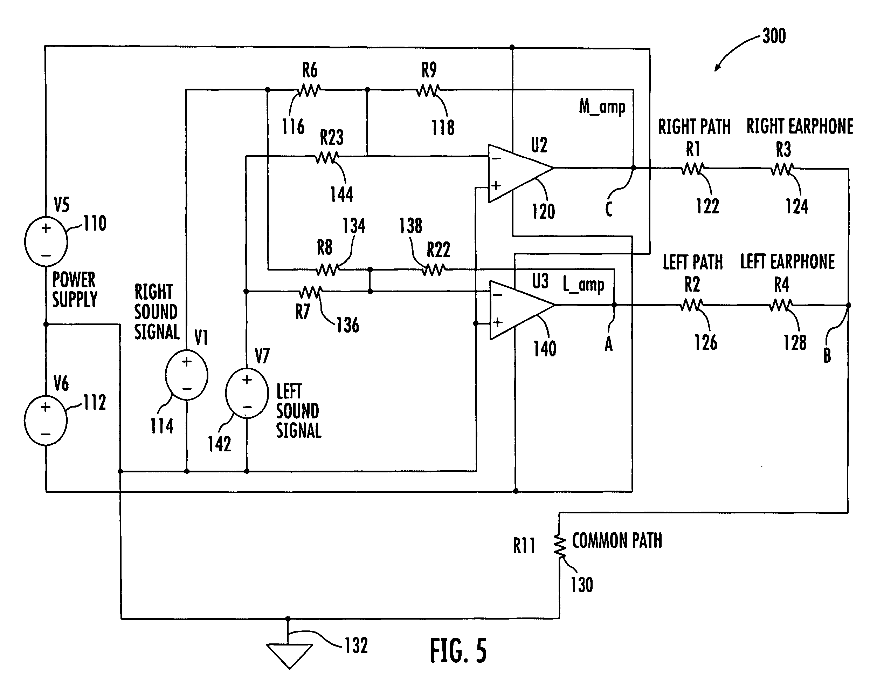

Referring now to Figure 5, Figure 5 presents a diagram illustrating a system **300** that rejects crosstalk between two channels of a system that communicate signals simultaneously or nearly simultaneously, in accordance with embodiments of the present invention. In Figure 5, each channel (i.e., the channel associated with the right earphone, R3, and the channel associated with the left earphone, R4) simultaneously function as both a sending channel and a victim channel. As explained previously, the sending channel generates a compensation signal that rejects the crosstalk on the victim channel. The description of the system with respect to Figures 1 and 3 also applies to the system presented in Figure 5.

In addition to the elements described in Figures 1 and 3, Figure 5 includes a second voltage source, V7 **142.** V7 **142** is a voltage source or sound generator that sends out a signal (e.g., a 0.837 kHz signal) that is used as input to the amplifier U2 **120**. U2 **120** is an amplifier (e.g., an operational amplifier) that drives a current through the left earphone, R4 **128**. With respect to the Figures described herein, U2 **120** and U3 **140** may also be referred to as earphone output drivers. Therefore, the system presented in Figure 5 causes a 0.837 kHz sound signal to be injected at the left earphone, R4 **128**. As explained previously with respect to Figures 1 and 3, a 1 kHz sound signal is injected at the right earphone, R3 **124**. Both the 1 kHz sound signal injected at the right earphone, R3 **124,** and the 0.837 kHz sound signal injected at the left earphone, R4 **128,** have the same or substantially same signal level (e.g., the same or substantially same amplitude). In other embodiments, both the 1 kHz sound signal injected at the right earphone, R3 **124,** and the 0.837 kHz sound signal injected at the left earphone, R4 **128**, may have different signal levels. The present invention reduces the mixing of the sound signals generated by V1 **114** and V7 **142**. As used herein, "mixing" means that a portion of the sound signal generated by V1 **114** may slip into the left earphone channel which includes R4 **128,** and a portion of the sound signal generated by V7 **142** may slip into the right earphone channel which includes R3 **124**.

As explained previously with respect to Figure 3, at least some part of the sound signal (e.g., 1 kHz signal) generated by the voltage source V1 **114** is transmitted as input to the amplifier U3 **140**. Amplifier U3 **140** generates a voltage on L_amp (e.g., the voltage measured at point or node A). This voltage may substantially mirror the voltage at the common node (e.g., the voltage measured at point or node B). Since the voltage measured at point A substantially mirrors or matches the voltage measured at point B, the current flowing through the left path and the left earphone, R4 **128,** decreases when compared to the embodiment presented in Figure 1. Since the current flowing through the left earphone, R4 **128,** decreases at a particular frequency (e.g., at 1 kHz), the crosstalk that is measured for the system also decreases because as defined previously, the crosstalk for the system is the amount of current flowing through the left earphone, R4 **128,** relative to (e.g., difference between) the amount of current flowing through the right earphone, R3 **124**.

In the embodiment of the system presented in Figure 5, at least some part of the sound signal (e.g., 0.837 kHz signal) generated by the voltage source V7 **142** is transmitted as input to the amplifier U2 **120**. Amplifier U2 **120** generates a voltage on M_amp (e.g., the voltage measured at point or node C). This voltage may substantially mirror the voltage at the common node (e.g., the voltage measured at point or node B). Since the voltage measured at point C substantially mirrors or matches the voltage measured at point or node B, the current flowing through the right path and the right earphone, R3 **124,** decreases when compared to the embodiment presented in Figures 1 and 3. Since the current flowing through the right earphone, R3 **124,** decreases at a particular frequency (e.g., at 0.837 kHz), the crosstalk that is measured for the system also decreases because as defined previously, the crosstalk for the system is the amount of current flowing through the left earphone, R4 **128,** relative to (e.g., difference between) the amount of current flowing through the right earphone, R3 **124.**

In some embodiments, the part of the system to the left of U2 **120** and U3 **140** may be accomplished in the digital domain of the sound channels (e.g., the right earphone channel and the left earphone channel). Since the part of the system to left of U2 **120** and U3 **140** may be accomplished in the digital domain of the sound channels, that part of the system may be implemented in software, rather than hardware. Therefore, each of the signals in the system to the left of U2 **120** and U3 **140** are digital signals, rather than analog signals. For example, V7 **142** is a voltage source that sends out a digital signal (e.g., a 0.837 kHz signal) that is used as input to the amplifier U2 **120,** which causes a 0.837 kHz digital sound signal to be injected at the left earphone, R4 **128**. Additionally, as a further example, a 1 kHz digital sound signal is injected at the right earphone, R3 **124**. Both the 1 kHz digital sound signal injected at the right earphone, R3 **124,** and the 0.837 kHz digital sound signal injected at the left earphone, R4 **128,** may have the same or substantially same signal level (e.g., the same or substantially same amplitude). As explained previously, at least some part of the digital sound signal (e.g., 1 kHz signal) generated by the voltage source V1 **114** is transmitted as input to the amplifier U3 **140.** Additionally, as explained previously, at least some part of the digital sound signal (e.g., a 0.837 kHz signal) generated by the voltage source V7 **142** is transmitted as input to the amplifier U2 **120.** In alternate embodiments of the system, the entire system may be implemented in hardware only, without any software. In still alternate embodiments of the system, the entire system may be implemented in software only, without any hardware.

In alternate embodiments, both V1 1 **114** and V7 **142** may transmit signals associated with the same or similar frequency. In such embodiments, a system or computer program product described herein may automatically determine that V1 **114** and V7 **142** are transmitting signals associated with the same or similar frequency, and may be adapted to automatically consider this information (e.g., may use a compensation factor) when measuring the voltage and/or resistance over the common path or when determining characteristics of a digital compensation signal to be injected into one or more earphone channels.

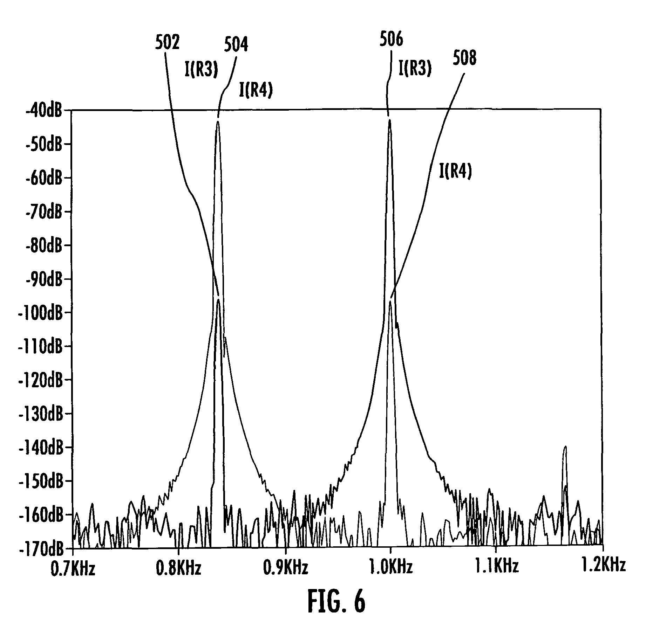

Referring now to Figure 6, Figure 6 presents a simulation graph (e.g., a Fast Fourier Transform (FFT) from a time-based simulation) associated with the system presented in Figure 5, in accordance with embodiments of the present invention. As presented in Figure 6, at 0.837 kHz, the current **504** measured through the left earphone is -43 dB and the current **502** measured through the right earphone is -96 dB. Therefore, the crosstalk associated with the 0.837 kHz signal is -53 dB, which is less than the crosstalk measured for the system in Figure 1 (-36 dB). Additionally, as presented in Figure 6, at 1 kHz, the current **508** measured through the left earphone is -43 dB and the current **506** measured through the right earphone is -96 dB. Therefore, the crosstalk associated with the 1 kHz signal is -53 dB, which is less than the crosstalk measured for the system in Figure 1 (-36 dB).

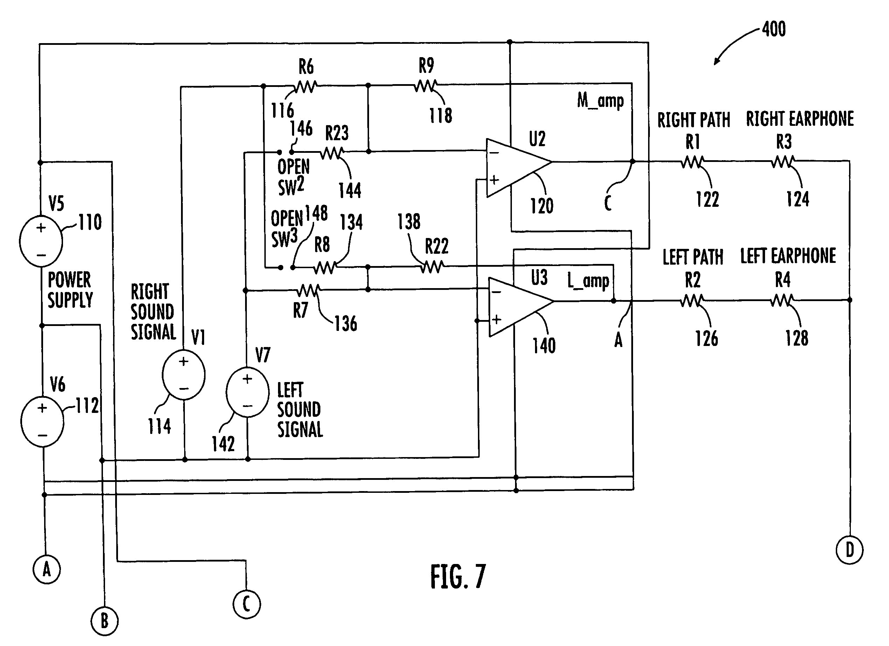

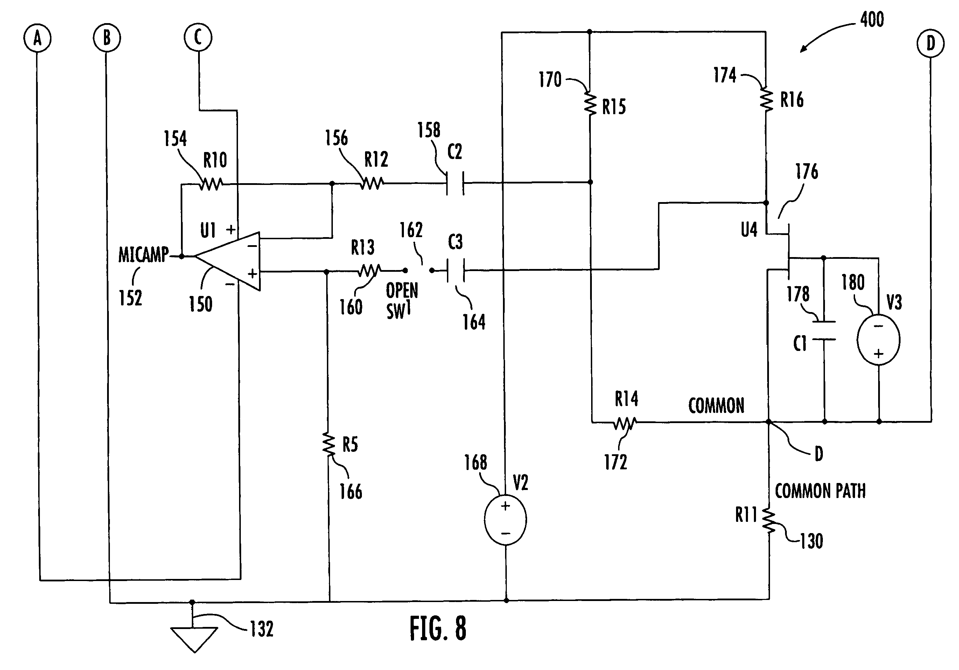

Referring now to Figures 7 and 8, Figures 7 and 8 presents a diagram of a first part and a second part of a system **400** that permits measurement of voltage and/or resistance in a common path (or any other path) or at the common node of the system, in accordance with embodiments of the present invention. Figures 7 and 8 will be explained together. The description of the system with respect to Figures 1,3, and 5 also applies to the system presented in Figures 7 and 8. In some embodiments, the part of the system presented in Figure 8 may be referred as the measuring module of the system. Therefore, in some embodiments, the measuring module includes a circuit that comprises a microphone. However, in other embodiments, the measuring module may include at least some part of the system presented in Figure 8 along with at least some part of the system presented in Figure 7.

The embodiment of the system presented in Figures 7 and 8 includes a configured microphone circuit in order to measure the voltage and/or the resistance on the common path of the circuit or the system. It is important to measure the voltage on the common path of the system in order to determine the characteristics (e.g., amplitude or signal value) of the compensation signal to be injected into the right channel (which includes right earphone, R3 **124**) and the characteristics (e.g., amplitude or signal value) of the compensation signal to be injected into the left channel (which includes left earphone, R4 **128**). Even though the measurement of the voltage and/or resistance on the common path should be made as close as possible to the connection point between the earphone channels, this is not always a practical possibility. Therefore, embodiments of the invention provide alternate strategies for measuring the voltage and/or resistance on the common path. In some embodiments, the system may measure the voltage and/or resistance on one part of the common path, where the voltage and/or resistance on another part of the common path may be calculated by design. In other embodiments, the system may calculate the voltage and/or resistance on a part of the common path using a measuring module as described herein and illustrated in Figures 7 and 8.

As explained with respect to Figure 5, in some embodiments, the part of the system to the left of U2 **120** and U3 **140** in Figures 7 and 8 may be accomplished in the digital domain of the sound channels (e.g., the right earphone channel and the left earphone channel). Since the part of the system to left of U2 **120** and U3 **140** may be accomplished in the digital domain of the sound channels, that part of the system may be implemented in software, rather than hardware (although it could be implemented in hardware in alternate embodiments). Additionally, in some embodiments, a substantial or entire part of the system illustrated in Figure 8 (referred to as the microphone circuit) may be implemented in software, rather than hardware (although it could be implemented in hardware in alternate embodiments).

In the embodiment of the system presented in Figures 7 and 8, **U4 176** is a transistor that represents a microphone. U1 **150** is an amplifier (e.g., operational amplifier) that senses the voltage and/or resistance on a part of the common path. R5 **166,** R10 **154,** R11 **130,** R12 **156,** R13 **160,** R14 **172,** R15 **170,** and R16 **174** are resistors. In some embodiments, R9 **118,** R22 **138,** R1 **122,** R2 **126,** R15 **170,** R16 **174**, R12 **156,** R13 **160,** R5 **166,** and R10 **154** are configured by design. R14 **172** emulates a virtual resistor inside microphone U4 **176,** and R14 **172** functions as a mirror of the microphone around its working point. R14 **172** may not perfectly mirror (e.g., variance of 10%) the virtual resistor inside the microphone **U4 176;** however, R14 **172** may be tuned to a value that delivers substantially optimal performance for standard earphone hardware. C1 **178,** C2 **158,** and C3 **164** are capacitors. V2 **168** and V3 **180** are voltage sources. V2 **168** is a bias generator that is substantially free from noise. V3 **180** is a sound generator. When measuring the voltage and/or the resistance in the common path of the system, V3 **180** is disconnected by opening the switch SW1 **162**. R6 **116** and R23 **144,** and R8 **134** and R7 **136** are representations of digital to analog (DA) convertors along with two additional input resistors to amplifier U2 **120** and U3 **140,** respectively. In one embodiment of the hardware solution, R6 **116** and R7 **136** are configured by design, while R8 **134** and R23 **144** are configurable resistor ladders.

In some embodiments, for the purposes of making the measurement of the voltage and/or resistance on the common path, the earphone impedances, R3 **124** and R4 **128,** are treated as unknown quantities. In some embodiments, the system calculates the earphone impedances, R3 **124** and R4 **128,** based on values associated with other resistors and/or based on values associated with other measurements in the system (e.g., measured voltage at **152** when SW 1 **162,** SW2 **146,** and SW3 **148** are opened). The system may subsequently use these values to calculate values for R8 **134** and R23 **144,** which may be used to calculate the voltage and/or resistance over the common path of the system.

As explained previously, in some embodiments, the system may calculate the voltage and/or resistance on a part of the common path using a measuring module as described herein and illustrated in Figures 7 and 8. In the embodiment of the system presented in Figures 7 and 8, the microphone U4 **176** with the amplifier U1 **150** measures the voltage and/or the resistance in the common path of the system. During normal functionality, switches SW1 **162,** SW2 **146,** and SW3 **148** are closed. In order to make the measurement described herein, the microphone U4 **176** is disconnected by opening the switch, SW1 **162,** on the positive input of the amplifier U1 **150**. The switch SW1 **162** is included in the system because the switch is need for one configuration of the audio block. Additionally, in some embodiments, two other switches may also be provided in the system in order to facilitate the measurement of the voltage and/or the resistance in the common path. These two other switches are represented by SW2 **146** and SW3 **148** in Figure 7. However, unlike SW1 **162,** which is usually a switch implemented in hardware, the switches SW2 **146** and SW3 **148** may be implemented in hardware or software.

In alternate embodiments, the switch SW1 **162** may be implemented in software rather than hardware, and either or both of the switches, SW2 **146** and SW3 **148,** may be implemented in hardware rather than software. In order to make the measurement of the voltage and/or the resistance in the common path, the three switches (SW1 **162,** SW2 **146,** and SW3 **148**) are opened. In other embodiments, the measurement of the voltage and/or the resistance in the common path may be made with opening one or more (but not all three) of the switches SW1 **162,** SW2 **146**, and SW3 **148**. Opening SW1 **162** disconnects the sound generator V3 **180** and opening SW2 **146** and SW3 **148** disconnects the crosstalk elimination function of the system. One or more of the voltage sources in the system may be configured to transmit a short "beep" sound signal on both the right channel (which includes right earphone, R3 **124**) and the left channel (which includes left earphone, R4 **128**) either before, after, or during opening the switches SW1 **162,** SW2 **146,** and SW3 **148** in the system. Additionally, the amplifier (e.g., U1 **150**) may be set to maximize the gain associated with the signal input to the amplifier (e.g., U1 **150**). By executing the steps described herein, an estimation of the voltage and/or resistance in the common path of the system may be achieved.

Additionally, as explained previously, the systems, methods, and computer program products described herein can be adapted to be used with any pre-existing or to-be-invented PHF earphone hardware. Additionally, the systems, methods, and computer program products described herein can be adapted to be used with earphone hardware associated with different impedances (e.g., the resistance values used for the right earphone, R3 **124,** and the left earphone, R4 **128** may be different from those presented in Figures 3, 5, and 7). Additionally, the systems, methods, and computer program products described herein can be adapted to be used with earphone hardware that includes multiple earphone channels, where each earphone channel is associated with a different impedance or resistance. As used herein, earphone hardware may include one earphone, two earphones, or more than two earphones. In embodiments with more than two earphones, a compensation signal is injected from a voltage source (or from one or more voltage sources) to each earphone channel.

An embodiment of the computer program product described herein that is embodied as a software program can be installed in an audio player that is connected to earphone hardware or can be installed in a computer that is connected to earphone hardware. In still other embodiments, the software program may be directly programmed into programmable earphone hardware. The installed software reduces crosstalk between multiple earphone channels associated with the earphone software. In some embodiments, the installed software is always active. In other embodiments, the installed software is activated when the earphone hardware receives electrical signals to convert into audible sound or when the earphone hardware emits audible sound. The invention (including any hardware or software associated with the invention) can be adapted to be used with (or can be tuned to work with) any audio producing device (e.g., wired or wireless headphones, earphones, etc.) that includes one or more earphones.

When connecting earphone hardware, or any other accessory that includes a microphone circuit, to an audio system or a computer that includes a computer program product described herein, the computer program product described herein may be triggered to initiate the transmission of a short beep as a notice to a user of the system that the earphone hardware is connected to the audio system or the computer. Alternatively or additionally, in some embodiments, an embodiment of the computer program product described herein may be triggered to initiate presentation of a graphical indicator on a display associated with the system as a notice to a user of the system that the earphone hardware is connected to the audio system or the computer.

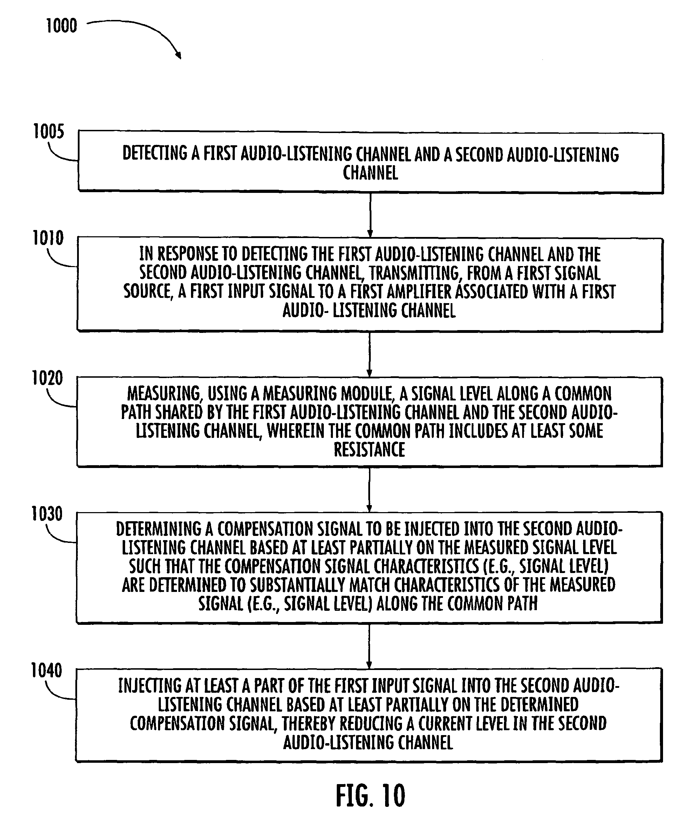

Additionally, in some embodiments, when the earphone hardware is connected to the audio system or computer, an embodiment of the computer program product described herein 1) initiates the disabling of the crosstalk elimination function of the computer program product (e.g., disabling the injecting step- block **1040** of Figure 10), and 2) sets the gain of the amplifier (e.g., U1 **150**) in the microphone circuit to a maximum level. Additionally, in some embodiments, when the earphone hardware is connected to the audio system or computer, an embodiment of the computer program product described herein disables an input signal associated with the microphone circuit (e.g., the input signal to the amplifier in the microphone circuit, U1 **150**) in Figure 8. As explained previously, this step may be performed by opening the switch SW1 **162** in Figure 8. When these steps have been executed, an embodiment of the computer program product described herein may be able to measure the voltage and/or resistance over the common path. This measured voltage and/or resistance may be used to calculate the characteristics of the compensation signal that has to be generated in order to reject crosstalk over one or more victim channels.

Since this voltage and/or resistance is calculated by a computer program product that operates in the digital domain, the characteristics of the compensation signal is also generated in the digital domain (e.g., a digital signal waveform). Therefore, as indicated previously, a computer program product described herein generates a digital compensation signal. In some embodiments, this digital compensation signal may be generated based at least partially on the amount of earphone impedance associated with the one or more earphone channels of the earphone hardware connected to the system in which the computer program product is installed. Additionally, the digital compensation signal may be adapted to small errors associated with impedances of earphones or earphone channels of the connected earphone hardware. In some embodiments, these errors may be errors associated with the frequency response of the earphones or earphone channels.

In some embodiments, the measurement of the voltage and/or resistance over the common path (or the digital compensation signal) may require several parameters to be measured prior to the measurement of the voltage and/or resistance over the common path. These parameters may be used to determine the characteristics (e.g., amplitude or signal value) of the compensation signal to be injected into the right channel (which includes right earphone, R3 **124**) and the characteristics (e.g., amplitude or signal value) of the compensation signal to be injected into the left channel (which includes left earphone, R4 **128**).

For example, an embodiment of the computer program product described herein may measure the output signal or voltage levels from the earphone drivers, i.e., amplifiers U2 **120** and U3 **140** in Figure 7. These signal or voltage levels may be considered by the computer program product in measuring the voltage and/or resistance over the common path (or in determining the digital compensation signal). Additionally, as a further example, an embodiment of the computer program product described herein may measure an input signal level from the amplifier in the microphone circuit, U1 **150.** This measured input signal level makes it possible calculate the quotient between the resistance in the earphone channel or path and the resistance in the common channel or path. Therefore, this measured input signal level or calculated quotient may be considered by the computer program product in measuring the voltage and/or resistance over the common path (or in determining the digital compensation signal).

Additionally, as a further example, an embodiment of the computer program product described herein may measure the frequencies of the signals at various nodes in the system, e.g., frequencies associated with signals produced by V1, V7, V2, V3, V5, and V6 at various nodes in the system. In some embodiments, the amplifiers may be configured to alter the frequencies (e.g., through a filtering mechanism in conjunction with other components of the circuit such as capacitors, resistors, etc.) associated with the signals produced by the voltage sources, and in such embodiments, an embodiment of the computer program product described herein may consider the altered frequencies in measuring the voltage and/or resistance over the common path (or in determining the digital compensation signal).

Additionally, as a further example, an embodiment of the computer program product described herein may estimate a compensation factor in embodiments where the system (e.g., the microphone circuit in the system) is configured to measure the resistance and/or voltage along a partial portion of the common path in the system. Such embodiments include instances where there is a connector between resistor R14 172 in Figure 8 and the point or node (e.g., node D in Figure 8) of the system where the common path begins. Therefore, an embodiment of the computer program product described herein may consider the compensation factor in measuring the voltage and/or resistance over the common path (or in determining the digital compensation signal).

As explained previously, one or more of the above-described parameters may be used to measure the voltage and/or resistance over the common path and/or determine the characteristics (e.g., amplitude or signal value) of the compensation signal to be injected into the right channel (which includes right earphone, R3) and the characteristics (e.g., amplitude or signal value) of the compensation signal to be injected into the left channel (which includes left earphone, R4).

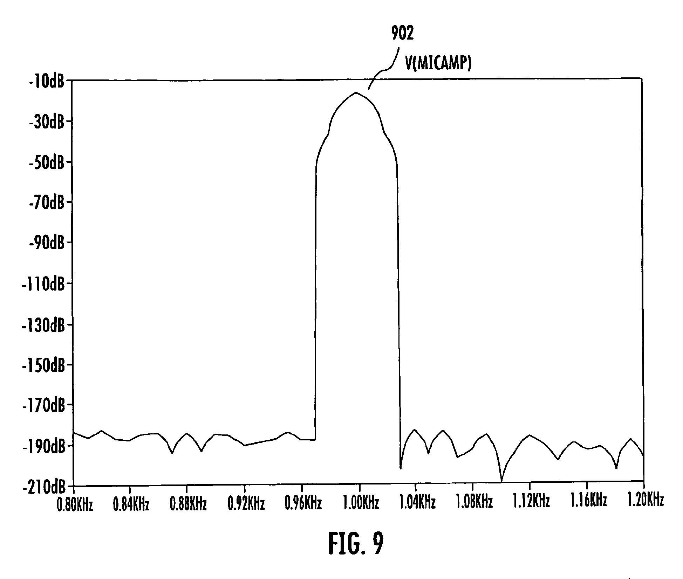

Referring now to Figure 9, Figure 9 presents a simulation graph, in accordance with embodiments of the present invention. The voltage in the common path of the system may be measured by measuring the voltage **902** at the "Micamp" node. As indicated in Figure 9, the voltage level **902** is -15dB.

In the embodiments, a system or a computer program product described herein may measure the current flowing through the first earphone channel (e.g., channel that includes R3 of Figure 7) and the current flowing through the second earphone channel (e.g., channel that includes R4 of Figure 7). The system or computer program product may subsequently calculate the crosstalk (e.g., difference between the current level in the first audio-listening channel and the current level in the second audio-listening channel) based on these measured values. Subsequently, the system or computer program product compares the difference value to a pre-determined threshold crosstalk level. In response to determining a difference between the current level in the first audio-listening channel and the current level in the second audio-listening channel is greater than the pre-determined threshold level (i.e., the crosstalk is greater than a pre-determined threshold level), the system or computer program product described herein performs the steps of Figure 10 (e.g., measuring the signal level over the common path; determining characteristics of a compensation signal to be injected into a victim channel; injecting, into the victim channel, at least some part of the input signal that is transmitted to an amplifier associated with the sending channel, etc.). In such embodiments, the steps of Figure 10 may not be performed by a system or computer program product described herein if the difference between the current level in the first audio-listening channel and the current level in the second audio-listening channel is not greater than a pre-determined threshold level (i.e., the crosstalk is not greater than a pre-determined threshold level).

In still other embodiments, the system or a computer program product described herein may measure the current flowing through only the victim earphone channel (e.g., channel that includes R4 **128** of Figure 7). The system or computer program product described herein may subsequently compare the current flowing through the victim earphone channel with a pre-determined threshold level to determine whether the current flowing through the victim earphone channel is greater than the pre-determined threshold level. If the current through the victim earphone channel is greater than the pre-determined threshold level, the system or computer program product described herein may use this determination as an indication that the crosstalk is greater than a pre-determined crosstalk threshold. In such embodiments where the current through the victim earphone channel is greater than a pre-determined threshold level, the system or computer program product described herein performs the steps of Figure 10 (e.g., measuring the signal level over the common path; determining characteristics of a compensation signal to be injected into a victim channel; injecting, into the victim channel, at least some part of the input signal that is transmitted to an amplifier associated with the sending channel, etc.). In such embodiments, the steps of Figure 10 may not be performed by a system or computer program product described herein if the current through the victim earphone channel is not greater than a pre-determined threshold level. In other embodiments, the steps of Figure 10 may be performed without making the initial measurement of the current level flowing through the victim earphone channel.

Referring now to Figure 10, Figure 10 presents a flowchart **1000** illustrating a general process flow for reducing crosstalk between two earphone channels, in accordance with embodiments of the present invention. Each of the blocks may be executed by a system or by a computer program product. Additionally, the blocks may be executed in an order that is different from the order indicted in Figure 10. Additionally, execution of each step presented in Figure 10 may trigger the execution of a successive step presented in Figure 10. At block **1005,** a system detects connection of at least two earphone channels (e.g., a left earphone channel and a right earphone channel), where in some embodiments, the two earphone channels may be connected via a common connector to the system. At block **1010,** the system, in response to detecting the first earphone channel and the second earphone channel, transmits, from a first signal source located in the system, a first input signal to a first amplifier associated with the first earphone channel. In some embodiments, the first earphone channel may be the sending channel, while the second earphone channel may be the victim channel. At block **1020**, a system measures the signal or voltage level over a common path (which includes at least some resistance) or at the common node associated with the multiple earphone channels. A measuring module associated with or included in the system makes the measurement at block **1020**. In some embodiments, this measuring step may be performed by the measuring module at a frequency associated with the first input signal. At block **1030,** based on the measured signal or voltage level over the common path (block **1020**), the system determines the characteristics (e.g., amplitude or signal value, signal frequency, etc.) of the compensation signal to be injected into the victim channel (which includes an earphone, e.g., a left earphone). The characteristics of the compensation signal are determined such that the compensation signal level (or voltage level) substantially mirrors characteristics (e.g., signal value) of the signal over the common path. At block **1040,** based on the characteristics of the compensation signal determined at block **1030,** at least some part of the sound signal (where the part of the sound signal may also be referred to as the compensation signal) generated by the voltage source associated with the sending channel is transmitted as input to the amplifier associated with the victim channel. Since the signal or voltage level associated with the compensation signal substantially mirrors voltage level or signal level over the common path, the current flowing through the victim channel decreases. Since the current flowing through the victim channel decreases, the crosstalk that is measured for the system also decreases because as defined previously, the crosstalk for the system is the amount of current flowing through the victim channel relative to (e.g., difference between) the amount of current flowing through another channel (which includes an earphone, e.g., a right earphone).

In accordance with embodiments of the invention, the term "module" with respect to a system (or a device) may refer to a hardware component of the system, a software component of the system, or a component of the system that includes both hardware and software. Hardware components may include one or more of the circuits or one or more partial portions of the circuits illustrated in Figures 1, 3, 5, 7, and 8. As used herein, a module may include one or more modules, where each module may reside in separate pieces of hardware or software.

Although many embodiments of the present invention have just been described above, the present invention may be embodied in many different forms and should not be construed as limited to the embodiments set forth herein; rather, these embodiments are provided so that this disclosure will satisfy applicable legal requirements. Also, it will be understood that, where possible, any of the advantages, features, functions, devices, and/or operational aspects of any of the embodiments of the present invention described and/or contemplated herein may be included in any of the other embodiments of the present invention described and/or contemplated herein, and/or vice versa. In addition, where possible, any terms expressed in the singular form herein are meant to also include the plural form and/or vice versa, unless explicitly stated otherwise. Accordingly, the terms "a" and/or "an" shall mean "one or more," even though the phrase "one or more" is also used herein. Like numbers refer to like elements throughout.

As will be appreciated by one of ordinary skill in the art in view of this disclosure, the present invention may include and/or be embodied as an apparatus (including, for example, a system, machine, device, computer program product, and/or the like), as a method (including, for example, a business method, computer-implemented process, and/or the like), or as any combination of the foregoing. Accordingly, embodiments of the present invention may take the form of an entirely business method embodiment, an entirely software embodiment (including firmware, resident software, micro-code, stored procedures in a database, etc.), an entirely hardware embodiment, or an embodiment combining business method, software, and hardware aspects that may generally be referred to herein as a "system." Furthermore, embodiments of the present invention may take the form of a computer program product that includes a computer-readable storage medium having one or more computer-executable program code portions stored therein. As used herein, a processor, which may include one or more processors, may be "configured to" perform a certain function in a variety of ways, including, for example, by having one or more general-purpose circuits perform the function by executing one or more computer-executable program code portions embodied in a computer-readable medium, and/or by having one or more application-specific circuits perform the function.

It will be understood that any suitable computer-readable medium may be utilized. The computer-readable medium may include, but is not limited to, a non-transitory computer-readable medium, such as a tangible electronic, magnetic, optical, electromagnetic, infrared, and/or semiconductor system, device, and/or other apparatus. For example, in some embodiments, the non-transitory computer-readable medium includes a tangible medium such as a portable computer diskette, a hard disk, a random access memory (RAM), a read-only memory (ROM), an erasable programmable read-only memory (EPROM or Flash memory), a compact disc read-only memory (CD-ROM), and/or some other tangible optical and/or magnetic storage device. In other embodiments of the present invention, however, the computer-readable medium may be transitory, such as, for example, a propagation signal including computer-executable program code portions embodied therein.

One or more computer-executable program code portions for carrying out operations of the present invention may include object-oriented, scripted, and/or unscripted programming languages, such as, for example, Java, Perl, Smalltalk, C++, SAS, SQL, Python, Objective C, JavaScript, and/or the like. In some embodiments, the one or more computer-executable program code portions for carrying out operations of embodiments of the present invention are written in conventional procedural programming languages, such as the "C" programming languages and/or similar programming languages. The computer program code may alternatively or additionally be written in one or more multi-paradigm programming languages, such as, for example, F#.

Some embodiments of the present invention are described herein with reference to flowchart illustrations and/or block diagrams of apparatus and/or methods. It will be understood that each block included in the flowchart illustrations and/or block diagrams, and/or combinations of blocks included in the flowchart illustrations and/or block diagrams, may be implemented by one or more computer-executable program code portions. These one or more computer-executable program code portions may be provided to a processor of a general purpose computer, special purpose computer, and/or some other programmable data processing apparatus in order to produce a particular machine, such that the one or more computer-executable program code portions, which execute via the processor of the computer and/or other programmable data processing apparatus, create mechanisms for implementing the steps and/or functions represented by the flowchart(s) and/or block diagram block(s).

The one or more computer-executable program code portions may be stored in a transitory and/or non-transitory computer-readable medium (e.g., a memory, etc.) that can direct, instruct, and/or cause a computer and/or other programmable data processing apparatus to function in a particular manner, such that the computer-executable program code portions stored in the computer-readable medium produce an article of manufacture including instruction mechanisms which implement the steps and/or functions specified in the flowchart(s) and/or block diagram block(s).

The one or more computer-executable program code portions may also be loaded onto a computer and/or other programmable data processing apparatus to cause a series of operational steps to be performed on the computer and/or other programmable apparatus. In some embodiments, this produces a computer-implemented process such that the one or more computer-executable program code portions which execute on the computer and/or other programmable apparatus provide operational steps to implement the steps specified in the flowchart(s) and/or the functions specified in the block diagram block(s). Alternatively, computer-implemented steps may be combined with, and/or replaced with, operator- and/or human-implemented steps in order to carry out an embodiment of the present invention.

While certain exemplary embodiments have been described and shown in the accompanying drawings, it is to be understood that such embodiments are merely illustrative of and not restrictive on the broad invention, and that this invention not be limited to the specific constructions and arrangements shown and described, since various other changes, combinations, omissions, modifications and substitutions, in addition to those set forth in the above paragraphs, are possible. Those skilled in the art will appreciate that various adaptations, modifications, and combinations of the just described embodiments can be configured without departing from the scope of the invention. Therefore, it is to be understood that, within the scope of the appended claims, the invention may be practiced other than as specifically described herein.

## Claims

1. A method for reducing crosstalk in an audio-listening channel, the method comprising:
detecting a first audio-listening channel (122) and a second audio-listening channel (126);
measuring a current level in the first audio-listening channel (122);
measuring a current level in the second audio-listening channel (126); and
comparing the current level in the first audio-listening channel (122) and the current level in the second audio-listening channel (126) to determine that a difference between the current level in the first audio-listening channel (122) and the current level in the second audio-listening channel (126) is greater than a predetermined threshold level;
in response to determining that the difference between the current level in the first audio-listening channel (122) and the current level in the second audio-listening channel (126) is greater than the predetermined threshold level, transmitting from a first signal source (114) a first input signal to a first amplifier (120) associated with the first audio-listening channel (122);
measuring a signal level along at least a partial portion of the common path (130) shared by the first audio-listening channel (122) and the second audio-listening channel (126), wherein the common path (130) includes at least some resistance;
determining a compensation signal to be injected into the second audio-listening channel (126) based at least partially on the measured signal level; and
injecting at least a part of the first input signal into the second audio-listening channel (126) based at least partially on the determined compensation signal, thereby reducing a current level in the second audio-listening channel (126).

2. The method of claim 1, further comprising:
transmitting from a second signal source (142) a second input signal to a second amplifier (140) associated with the second audio-listening channel (126); and
injecting at least a part of the second input signal into the first audio-listening channel (122) based at least partially on the measured signal level, thereby reducing a current level in the first audio-listening channel (122).

3. The method of claim 2, wherein the step of injecting at least a part of the first input signal into the second audio-listening channel (126) is performed substantially simultaneously with the injecting at least a part of the second input signal into the first audio-listening channel (122).

4. The method of claim 1, wherein the first signal source is a voltage source and the signal level is a voltage level.

5. The method of claim 1, wherein the first audio-listening channel (122) includes a first earphone associated with a first impedance and the second audio-listening channel (126) includes a second earphone associated with a second impedance.

6. The method of claim 2, wherein the first input signal is associated with a first frequency and the second input signal is associated with a second frequency different from the first frequency.

7. The method of claim 1, wherein at least one of the transmitting, measuring, determining, or injecting steps is performed in a digital domain.

8. The method of claim 1, wherein the detecting step further comprises:
detecting a connector inserted into an audio-producing system, wherein the connector is associated with the first audio-listening channel (122) and the second audio-listening channel (126).

9. The method of claim 1, further comprising:
in response to detecting the first audio-listening channel (122) and the second audio-listening channel (126), producing an audible beep.

10. The method of claim 1, wherein the measuring step further comprises:
determining a first impedance associated with the first audio-listening channel (122);
determining a second impedance associated with the second audio-listening channel (126); and
measuring the signal level along the common path (130) based at least partially on the first impedance and the second impedance.

11. The method of claim 1, wherein the measuring step further comprises:
disabling an injecting module that performs the injecting step;
disabling an input signal provided to an amplifier located in a measuring module; and
maximizing a gain associated with the amplifier located in the measuring module, wherein the measuring step is performed using the measuring module.

12. The method of claim 2, wherein the step of measuring a signal level along at least a partial portion of the common path (130) shared by the first audio-listening channel (122) and the second audio-listening channel (126) further comprises measuring an output signal level associated with the first amplifier (120) and measuring an output signal level associated with the second amplifier (140).

13. The method of claim 2, wherein the step of measuring a signal level along at least a partial portion of the common path (130) shared by the first audio-listening channel (122) and the second audio-listening channel (126) further comprises measuring an input signal level associated with an amplifier (150) located in the measuring module.

14. The method of claim 2, wherein the measuring step is performed using a measuring module and the step of measuring a signal level along at least a partial portion of the common path (130) shared by the first audio-listening channel (122) and the second audio-listening channel (126) further comprises using a compensation factor associated with the configuration of the measuring module.

15. The method of claim 1, wherein the measuring step is performed using a measuring module; and wherein the measuring module includes a circuit comprising a microphone (176).

16. The method of claim 1, further comprising:
measuring a current level in the second audio-listening channel (126); and
comparing the current level in the second-audio listening channel and a predetermined threshold current level to determine that the current level in the second audio-listening channel (126) is greater than the predetermined threshold current level.

17. The method of claim 1, further comprising:
providing an application;
determining a maximum crosstalk value associated with the application;
comparing a current level in the first audio-listening channel (122) and a current level in the second audio-listening channel (126) to determine a measured crosstalk value;
comparing the measured crosstalk value and the maximum crosstalk value to determine that the measured crosstalk value is less than or equal to the maximum crosstalk value; and
permitting execution of the application.

18. A computer program for reducing crosstalk in an audio-listening channel, the computer program product comprising:
a non-transitory computer readable medium comprising code configured to cause a computer to:
detect a first audio-listening channel (122) and a second audio-listening channel (126);
measure a current level in the first audio-listening channel (122);
measure a current level in the second audio-listening channel (126); and
compare the current level in the first audio-listening channel (122) and the current level in the second audio-listening channel (126) to determine that a difference between the current level in the first audio-listening channel (122) and the current level in the second audio-listening channel (126) is greater than a predetermined threshold level;
in response to determining that the difference between the current level in the first audio-listening channel (122) and the current level in the second audio-listening channel (126) is greater than the predetermined threshold level, transmit from a first signal source (114) a first input signal to a first amplifier (120) associated with the first audio-listening channel (122);
measure a signal level along at least a portion of a common path (130) shared by the first audio-listening channel (122) and a second audio-listening channel (126), wherein the common path (130) includes at least some resistance;
determine a digital compensation signal to be injected into the second audio-listening channel (126) based at least partially on the measured signal level; and
inject at least a part of the first input signal into the second audio-listening channel (126) based at least partially on the determined compensation signal, thereby reducing a current level in the second audio-listening channel (126).

19. A system for reducing crosstalk in an audio-listening channel, the system comprising:
a memory;
a processor;
a module stored in the memory, executable by the processor, and configured to:
detect a first audio-listening channel (122) and a second audio-listening channel (126);
measure a current level in the first audio-listening channel (122);
measure a current level in the second audio-listening channel (126); and
compare the current level in the first audio-listening channel (122) and the current level in the second audio-listening channel (126) to determine that a difference between the current level in the first audio-listening channel (122) and the current level in the second audio-listening channel (126) is greater than a predetermined threshold level;
in response to determining that the difference between the current level in the first audio-listening channel (122) and the current level in the second audio-listening channel (126) is greater than the predetermined threshold level, transmit from a first signal source (114) a first input signal to a first amplifier (120) associated with the first audio-listening channel (122);
measure a signal level over at least a portion of a common path (130) shared by the first audio-listening channel (122) and a second audio-listening channel (126), wherein the common path (130) includes at least some resistance;
determine a compensation signal to be injected into the second audio-listening channel (126) based at least partially on the measured signal level; and
divert at least a part of the first input signal to the second audio-listening channel (126) based at least partially on the determined compensation signal, thereby causing an output signal level of a second amplifier associated with the second audio-listening channel (126) to substantially match the signal level over the common path (130).

## Patentansprüche

1. Ein Verfahren zur Reduzierung eines Übersprechens in einem Audiohörkanal, wobei das Verfahren umfasst:
Detektieren eines ersten Audiohörkanals (122) und eines zweiten Audiohörkanals (126);
Messen eines Stromniveaus in dem ersten Audiohörkanal (122);
Messen eines Stromniveaus in dem zweiten Audiohörkanal (126); und
Vergleichen des Stromniveaus in dem ersten Audiohörkanal (122) und des Stromniveaus in dem zweiten Audiohörkanal (126) zum Bestimmen, dass eine Differenz zwischen dem Stromniveau in dem ersten Audiohörkanal (122) und dem Stromniveau in dem zweiten Audiohörkanal (126) größer als ein vorbestimmter Schwellenwert ist;
in Reaktion auf die Bestimmung, dass die Differenz zwischen dem Stromniveau in dem ersten Audiohörkanal (122) und dem Stromniveau in dem zweiten Audiohörkanal (126) größer als der vorbestimmte Schwellenwert ist, Übertragen von einer ersten Signalquelle (114) ein erstes Eingangssignal an einen ersten Verstärker (120), verknüpft mit dem ersten Audiohörkanal (122);
Messen eines Signalniveaus entlang zumindest einem Teilabschnitt des gemeinsamen Pfads (130), welcher dem ersten Audiohörkanal (122) und dem zweiten Audiokanal (126) gemeinsam ist, wobei der gemeinsame Pfad (130) zumindest etwas Widerstand umfasst;
Bestimmen eines Kompensationssignals, welches in den zweiten Audiohörkanal (126) einzukoppeln ist, basierend zumindest teilweise auf dem gemessenen Signalniveau; und
Einkoppeln von zumindest einem Teil des ersten Eingangssignals in den zweiten Audiohörkanal (126) basierend zumindest teilweise auf dem bestimmten Kompensationssignal, wodurch ein Stromniveau in dem zweiten Audiohörkanal (126) reduziert wird.

2. Verfahren gemäß Anspruch 1, weiter umfassend:
Übertragen von einer zweiten Signalquelle (142) ein zweites Eingangssignal an einen zweiten Verstärker (140), verknüpft mit dem zweiten Audiohörkanal (126); und
Einkoppeln von zumindest einem Teil des zweiten Eingangssignals in den ersten Audiohörkanal (122), basierend zumindest teilweise auf dem gemessenen Signalniveau, wodurch ein Stromniveau in dem ersten Audiohörkanal (122) reduziert wird.

3. Verfahren gemäß Anspruch 2, wobei der Schritt zum Einkoppeln von zumindest einem Teil des ersten Eingangssignals in den zweiten Audiohörkanal (126) im Wesentlichen gleichzeitig mit dem Einkoppeln von zumindest einem Teil des zweiten Eingangssignals in den ersten Audiohörkanal (122) ausgeführt wird.

4. Verfahren gemäß Anspruch 1, wobei die erste Signalquelle eine Spannungsquelle ist und das Signalniveau ein Spannungsniveau ist.

5. Verfahren gemäß Anspruch 1, wobei der erste Audiohörkanal (122) einen ersten Kopfhörer umfasst, verknüpft mit einer ersten Impedanz, und der zweite Audiohörkanal (126) einen zweiten Kopfhörer umfasst, verknüpft mit einer zweiten Impedanz.

6. Verfahren gemäß Anspruch 2, wobei das erste Eingangssignal mit einer ersten Frequenz verknüpft ist und das zweite Eingangssignal mit einer zu der ersten Frequenz unterschiedlichen zweiten Frequenz verknüpft ist.

7. Verfahren gemäß Anspruch 1, wobei zumindest die Übertragungs-, Mess-, Bestimmungs- oder Einkopplungs-Schritte in einer digitalen Domain ausgeführt werden.

8. Verfahren gemäß Anspruch 1, wobei der Detektionsschritt weiter umfasst:
Detektieren eines in ein Audio-Erzeugungssystem eingeführten Verbindungselements, wobei das Verbindungselement mit dem ersten Audiohörkanal (122) und dem zweiten Audiohörkanal (126) verknüpft ist.

9. Verfahren gemäß Anspruch 1, weiter umfassend:
in Reaktion auf das Detektieren des ersten Audiohörkanals (122) und des zweiten Audiohörkanals (126), Erzeugen eines hörbaren Pieptons.

10. Verfahren gemäß Anspruch 1, wobei der Messschritt weiter umfasst:
Bestimmen einer ersten Impedanz, verknüpft mit dem ersten Audiohörkanal (122);
Bestimmen einer zweiten Impedanz, verknüpft mit dem zweiten Audiohörkanal (126); und
Messen des Signalniveaus entlang des gemeinsamen Pfads (130) basierend zumindest teilweise auf der ersten Impedanz und der zweiten Impedanz.

11. Verfahren gemäß Anspruch 1, wobei der Messschritt weiter umfasst:
Deaktivieren eines Einkopplungsmoduls, welches den Einkopplungsschritt ausführt;
Deaktivieren eines Eingangssignals, welches einem in einem Messmodul positionierten Verstärker bereitgestellt wird; und
Maximieren einer Verstärkung, verknüpft mit dem in dem Messmodul positionierten Verstärker, wobei der Messschritt unter Verwendung des Messmoduls ausgeführt wird.

12. Verfahren gemäß Anspruch 2, wobei der Messschritt ein Signalniveau entlang zumindest eines Teilabschnitts des gemeinsamen Pfads (130), welcher dem ersten Audiohörkanal (122) und dem zweiten Audiohörkanal (126) gemeinsam ist, weiter ein Messen eines mit dem ersten Verstärker (120) verknüpften Ausgangssignalniveaus und ein Messen eines mit dem zweiten Verstärker (140) verknüpften Ausgangssignalniveaus umfasst.

13. Verfahren gemäß Anspruch 2, wobei der Messschritt eines Signalniveaus entlang zumindest eines Teilabschnitts des gemeinsamen Pfads (130), welcher dem ersten Audiohörkanal (122) und dem zweiten Audiohörkanal (126) gemeinsam ist, weiter ein Messen eines mit einem in dem Messmodul positionierten Verstärker (150) verknüpften Eingangssignalniveaus umfasst.

14. Verfahren gemäß Anspruch 2, wobei der Messschritt unter Verwendung eines Messmoduls ausgeführt wird und der Messschritt eines Signalniveaus entlang zumindest eines Teilabschnitts des gemeinsamen Pfads (130), welcher dem ersten Audiohörkanal (122) und dem zweiten Audiohörkanal (126) gemeinsam ist, weiter ein Verwenden eines mit der Konfiguration des Messmoduls verknüpften Kompensationsfaktors umfasst.

15. Verfahren gemäß Anspruch 1, wobei der Messschritt unter Verwendung eines Messmoduls ausgeführt wird; und wobei das Messmodul einen ein Mikrofon (176) umfassenden Schaltkreis umfasst.

16. Verfahren gemäß Anspruch 1, weiter umfassend:
Messen eines Stromniveaus in dem zweiten Audiohörkanal (126); und
Vergleichen des Stromniveaus in dem zweiten Audiohörkanal und eines vorbestimmten Schwellenwert-Stromniveaus zum Bestimmen, dass das Stromniveau in dem zweiten Audiohörkanal (126) größer als das vorbestimmte Schwellenwert-Stromniveau ist.

17. Verfahren gemäß Anspruch 1, weiter umfassend:
Bereitstellen einer Anwendung;
Bestimmen eines mit der Anwendung verknüpften maximalen Übersprechwerts;
Vergleichen eines Stromniveaus in dem ersten Audiohörkanal (122) und eines Stromniveaus in dem zweiten Audiohörkanal (126) zum Bestimmen eines gemessenen Übersprechwerts;
Vergleichen des gemessenen Übersprechwerts und des maximalen Übersprechwerts zum Bestimmen, dass der gemessene Übersprechwert geringer oder gleich dem maximalen Übersprechwert ist; und
Zulassen einer Ausführung der Anwendung.

18. Ein Computerprogramm zum Reduzieren eines Übersprechens in einem Audiohörkanal, wobei das Computerprogrammprodukt umfasst:
ein nicht-flüchtiges computerlesbares Medium, umfassend Code, ausgebildet zum Veranlassen eines Computers zum:
Detektieren eines ersten Audiohörkanals (122) und eines zweiten Audiohörkanals (126);
Messen eines Stromniveaus in dem ersten Audiohörkanal (122) ;
Messen eines Stromniveaus in dem zweiten Audiohörkanal (126); und
Vergleichen des Stromniveaus in dem ersten Audiohörkanal (122) und des Stromniveaus in dem zweiten Audiohörkanal (126) zum Bestimmen, dass eine Differenz zwischen dem Stromniveau in dem ersten Audiohörkanal (122) und dem Stromniveau in dem zweiten Audiohörkanal (126) größer als ein vorbestimmter Schwellenwert ist;
in Reaktion auf das Bestimmen, dass die Differenz zwischen dem Stromniveau in dem ersten Audiohörkanal (122) und dem Stromniveau in dem zweiten Audiohörkanal (126) größer als der vorbestimmte Schwellenwert ist, Übertragen von einer ersten Signalquelle (114) ein erstes Eingangssignal an einen ersten Verstärker (120), verknüpft mit dem ersten Audiohörkanal (122);
Messen eines Signalniveaus entlang zumindest eines Teils eines gemeinsamen Pfads (130), welcher dem ersten Audiohörkanal (122) und einem zweiten Audiohörkanal (126) gemeinsam ist, wobei der gemeinsame Pfad (130) zumindest etwas Widerstand umfasst;
Bestimmen eines digitalen Kompensationssignals, welches in den zweiten Audiohörkanal (126) einzukoppeln ist, basierend zumindest teilweise auf dem gemessenen Signalniveau; und
Einkoppeln von zumindest einem Teil des ersten Eingangssignals in den zweiten Audiohörkanal (126), basierend zumindest teilweise auf dem bestimmten Kompensationssignal, wodurch ein Stromniveau in dem zweiten Audiohörkanal (126) reduziert wird.

19. Ein System zum Reduzieren eines Übersprechens in einem Audiohörkanal, wobei das System umfasst:
einen Speicher;
einen Prozessor;
ein Modul, gespeichert in dem Speicher, ausführbar durch den Prozessor und ausgebildet zum:
Detektieren eines ersten Audiohörkanals (122) und eines zweiten Audiohörkanals (126);
Messen eines Stromniveaus in dem ersten Audiohörkanal (122) ;
Messen eines Stromniveaus in dem zweiten Audiokanal (126); und
Vergleichen des Stromniveaus in dem ersten Audiohörkanal (122) und des Stromniveaus in dem zweiten Audiohörkanal (126) zum Bestimmen, dass eine Differenz zwischen dem Stromniveau in dem ersten Audiohörkanal (122) und dem Stromniveau in dem zweiten Audiohörkanal (126) größer als ein vorbestimmter Schwellenwert ist;
in Reaktion auf das Bestimmen, dass die Differenz zwischen dem Stromniveau in dem ersten Audiohörkanal (122) und dem Stromniveau in dem zweiten Audiohörkanal (126) größer als der vorbestimmte Schwellenwert ist, Übertragen von einer ersten Signalquelle (114) ein erstes Eingangssignal an einen ersten Verstärker (120), verknüpft mit dem ersten Audiohörkanal (122);
Messen eines Signalniveaus über zumindest einen Abschnitt eines gemeinsamen Pfads (130), welcher dem ersten Audiohörkanal (122) und einem zweiten Audiohörkanal (126) gemeinsam ist, wobei der gemeinsame Pfad (130) zumindest etwas Widerstand umfasst;
Bestimmen eines Kompensationssignals, welches in den zweiten Audiohörkanal (126) einzukoppeln ist, basierend zumindest teilweise auf dem gemessenen Signalniveau; und
Umlenken von zumindest einem Teil des ersten Eingangssignals zu dem zweiten Audiohörkanal (126) basierend zumindest teilweise auf dem bestimmten Kompensationssignal, wodurch veranlasst wird, dass ein Ausgangssignalniveau eines zweiten Verstärkers, verknüpft mit dem zweiten Audiohörkanal (126), im Wesentlichen mit dem Signalniveau über dem gemeinsamen Pfad (130) übereinstimmt.

## Revendications

1. Procédé pour réduire la diaphonie dans un canal d'écoute audio, le procédé comprenant le fait :
de détecter un premier canal d'écoute audio (122) et un deuxième canal d'écoute audio (126) ;
de mesurer un niveau de courant dans le premier canal d'écoute audio (122) ;
de mesurer un niveau de courant dans le deuxième canal d'écoute audio (126) ; et
de comparer le niveau de courant dans le premier canal d'écoute audio (122) et le niveau de courant dans le deuxième canal d'écoute audio (126) pour déterminer qu'une différence entre le niveau de courant dans le premier canal d'écoute audio (122) et le niveau de courant dans le deuxième canal d'écoute audio (126) est supérieure à un niveau seuil prédéterminé ;
de transmettre, en réponse à la détermination du fait que la différence entre le niveau de courant dans le premier canal d'écoute audio (122) et le niveau de courant dans le deuxième canal d'écoute audio (126) est supérieure au niveau seuil prédéterminé, à partir d'une première source de signal (114) un premier signal d'entrée à un premier amplificateur (120) associé au premier canal d'écoute audio (122) ;
de mesurer un niveau de signal le long d'au moins une partie partielle du chemin commun (130) partagé par le premier canal d'écoute audio (122) et par le deuxième canal d'écoute audio (126), où le chemin commun (130) comporte au moins une certaine résistance ;
de déterminer un signal de compensation à injecter dans le deuxième canal d'écoute audio (126) sur la base au moins en partie du niveau de signal mesuré ; et
d'injecter l'au moins une partie du premier signal d'entrée dans le deuxième canal d'écoute audio (126) sur la base au moins en partie du signal de compensation déterminé, réduisant ainsi un niveau de courant dans le deuxième canal d'écoute audio (126).

2. Procédé de la revendication 1, comprenant en outre le fait :
de transmettre à partir d'une deuxième source de signal (142) un deuxième signal d'entrée à un deuxième amplificateur (140) associé au deuxième canal d'écoute audio (126) ; et
d'injecter au moins une partie du deuxième signal d'entrée dans le premier canal d'écoute audio (122) sur la base au moins en partie du niveau de signal mesuré, réduisant ainsi un niveau de courant dans le premier canal d'écoute audio (122).

3. Procédé de la revendication 2, dans lequel l'étape qui consiste à injecter au moins une partie du premier signal d'entrée dans le deuxième canal d'écoute audio (126) est effectuée de manière essentiellement simultanée avec l'injection d'au moins une partie du deuxième signal d'entrée dans le premier canal d'écoute audio (122).

4. Procédé de la revendication 1, dans lequel la première source de signal est une source de tension et le niveau de signal est un niveau de tension.

5. Procédé de la revendication 1, dans lequel le premier canal d'écoute audio (122) comporte un premier écouteur associé à une première impédance et le deuxième canal d'écoute audio (126) comporte un deuxième écouteur associé à une deuxième impédance.

6. Procédé de la revendication 2, dans lequel le premier signal d'entrée est associé à une première fréquence et le deuxième signal d'entrée est associé à une deuxième fréquence différente de la première fréquence.

7. Procédé de la revendication 1, dans lequel au moins l'une des étapes de transmission, de mesure, de détermination ou d'injection est effectuée dans un domaine numérique.

8. Procédé de la revendication 1, dans lequel l'étape de détection comprend en outre le fait :
de détecter un connecteur inséré dans un système de production audio, où le connecteur est associé au premier canal d'écoute audio (122) et au deuxième canal d'écoute audio (126).

9. Procédé de la revendication 1, comprenant en outre le fait :
de produire, en réponse à la détection du premier canal d'écoute audio (122) et du deuxième canal d'écoute audio (126), un bip audible.

10. Procédé de la revendication 1, dans lequel l'étape de mesure comprend en outre le fait :
de déterminer une première impédance associée au premier canal d'écoute audio (122) ;
de déterminer une deuxième impédance associée au deuxième canal d'écoute audio (126) ; et
de mesurer le niveau de signal le long du chemin commun (130) sur la base au moins en partie de la première impédance et de la deuxième impédance.

11. Procédé de la revendication 1, dans lequel l'étape de mesure comprend en outre le fait :
de désactiver un module d'injection qui effectue l'étape d'injection ;
de désactiver un signal d'entrée fourni à un amplificateur situé dans un module de mesure ; et
de maximiser un gain associé à l'amplificateur situé dans le module de mesure, où l'étape de mesure est effectuée en utilisant le module de mesure.

12. Procédé de la revendication 2, dans lequel l'étape qui consiste à mesurer un niveau de signal le long d'au moins une partie partielle du chemin commun (130) partagé par le premier canal d'écoute audio (122) et par le deuxième canal d'écoute audio (126) comprend en outre le fait de mesurer un niveau de signal de sortie associé au premier amplificateur (120) et de mesurer un niveau de signal de sortie associé au deuxième amplificateur (140).

13. Procédé de la revendication 2, dans lequel l'étape qui consiste à mesurer un niveau de signal le long d'au moins une partie partielle du chemin commun (130) partagé par le premier canal d'écoute audio (122) et par le deuxième canal d'écoute audio (126) comprend en outre le fait de mesurer un niveau de signal d'entrée associé à un amplificateur (150) situé dans le module de mesure.

14. Procédé de la revendication 2, dans lequel l'étape de mesure est effectuée en utilisant un module de mesure et l'étape qui consiste à mesurer un niveau de signal le long d'au moins une partie partielle du chemin commun (130) partagé par le premier canal d'écoute audio (122) et par le deuxième canal d'écoute audio (126) comprend en outre le fait d'utiliser un facteur de compensation associé à la configuration du module de mesure.

15. Procédé de la revendication 1, dans lequel l'étape de mesure est effectuée en utilisant un module de mesure ; et où le module de mesure comporte un circuit comprenant un microphone (176).

16. Procédé de la revendication 1, comprenant en outre le fait :
de mesurer un niveau de courant dans le deuxième canal d'écoute audio (126) ; et
de comparer le niveau de courant dans le deuxième canal d'écoute audio et un niveau de courant seuil prédéterminé pour déterminer que le niveau de courant dans le deuxième canal d'écoute audio (126) est supérieur au niveau de courant seuil prédéterminé.

17. Procédé de la revendication 1, comprenant en outre le fait :
de fournir une application ;
de déterminer une valeur de diaphonie maximale associée à l'application ;
de comparer un niveau de courant dans le premier canal d'écoute audio (122) et un niveau de courant dans le deuxième canal d'écoute audio (126) pour déterminer une valeur de diaphonie mesurée ;
de comparer la valeur de diaphonie mesurée et la valeur de diaphonie maximale pour déterminer que la valeur de diaphonie mesurée est inférieure ou égale à la valeur de diaphonie maximale ; et
de permettre l'exécution de l'application.

18. Programme informatique pour réduire la diaphonie dans un canal d'écoute audio, le produit de programme informatique comprenant :
un support lisible par ordinateur non-transitoire comprenant un code configuré pour amener un ordinateur :
à détecter un premier canal d'écoute audio (122) et un deuxième canal d'écoute audio (126) ;
à mesurer un niveau de courant dans le premier canal d'écoute audio (122) ;
à mesurer un niveau de courant dans le deuxième canal d'écoute audio (126) ; et
à comparer le niveau de courant dans le premier canal d'écoute audio (122) et le niveau de courant dans le deuxième canal d'écoute audio (126) pour déterminer qu'une différence entre le niveau de courant dans le premier canal d'écoute audio (122) et le niveau de courant dans le deuxième canal d'écoute audio (126) est supérieure à un niveau seuil prédéterminé ;
à transmettre, en réponse à la détermination du fait que la différence entre le niveau de courant dans le premier canal d'écoute audio (122) et le niveau de courant dans le deuxième canal d'écoute audio (126) est supérieure au niveau seuil prédéterminé, à partir d'une première source de signal (114) un premier signal d'entrée à un premier amplificateur (120) associé au premier canal d'écoute audio (122) ;
à mesurer un niveau de signal le long d'au moins une partie d'un chemin commun (130) partagé par le premier canal d'écoute audio (122) et par un deuxième canal d'écoute audio (126), où le chemin commun (130) comporte au moins une certaine résistance ;
à déterminer un signal de compensation numérique à injecter dans le deuxième canal d'écoute audio (126) sur la base au moins en partie du niveau de signal mesuré ; et
à injecter au moins une partie du premier signal d'entrée dans le deuxième canal d'écoute audio (126) sur la base au moins en partie du signal de compensation déterminé, réduisant ainsi un niveau de courant dans le deuxième canal d'écoute audio (126).

19. Système pour réduire la diaphonie dans un canal d'écoute audio, le système comprenant .
une mémoire ;
un processeur ;
un module stocké dans la mémoire, pouvant être exécuté par le processeur, et configuré :
pour détecter un premier canal d'écoute audio (122) et un deuxième canal d'écoute audio (126) ;
pour mesurer un niveau de courant dans le premier canal d'écoute audio (122) ;
pour mesurer un niveau de courant dans le deuxième canal d'écoute audio (126) ; et
pour comparer le niveau de courant dans le premier canal d'écoute audio (122) et le niveau de courant dans le deuxième canal d'écoute audio (126) pour déterminer qu'une différence entre le niveau de courant dans le premier canal d'écoute audio (122) et le niveau de courant dans le deuxième canal d'écoute audio (126) est supérieure à un niveau seuil prédéterminé ;
pour transmettre, en réponse à la détermination du fait que la différence entre le niveau de courant dans le premier canal d'écoute audio (122) et le niveau de courant dans le deuxième canal d'écoute audio (126) est supérieure au niveau seuil prédéterminé, à partir d'une première source de signal (114) un premier signal d'entrée à un premier amplificateur (120) associé au premier canal d'écoute audio (122) ;
pour mesurer un niveau de signal sur au moins une partie d'un chemin commun (130) partagé par le premier canal d'écoute audio (122) et par un deuxième canal d'écoute audio (126), où le chemin commun (130) comporte au moins une certaine résistance ;
pour déterminer un signal de compensation à injecter dans le deuxième canal d'écoute audio (126) sur la base au moins en partie du niveau de signal mesuré ; et
pour détourner au moins une partie du premier signal d'entrée vers le deuxième canal d'écoute audio (126) sur la base au moins en partie du signal de compensation déterminé, amenant ainsi un niveau de signal de sortie d'un deuxième amplificateur associé au deuxième canal d'écoute audio (126) à correspondre essentiellement au niveau de signal sur le chemin commun (130).
